# EUROPEAN PATENT APPLICATION

(11) **EP 4 379 813 A1**
(43) Date of publication of application: **05.06.2024**
(21) Application number: 22849443.1
(22) Date of filing: 25.07.2022
(51) Int. Cl.: H01L 29/82, H01L 21/02, H10N 50/01

(54) **METHOD FOR MANUFACTURING SPIN WAVE EXCITATION/DETECTION STRUCTURE**

(30) Priority: 28.07.2021 JP 2021123389
(71) Applicant: Shin-Etsu Chemical Co., Ltd., Chiyoda-ku, Tokyo 1000005 (JP); National University Corporation Toyohashi University of Technology, Tempaku-cho, Toyohashi-shi, Aichi 441-8580 (JP)
(72) Inventor: WATANABE, Toshiaki, Annaka-shi, Gunma 379-0195 (JP); INOUE, Mitsuteru, Toyohashi-shi, Aichi 441-8580 (JP); GOTO, Taichi, Sendai-shi, Miyagi 9808577 (JP)
(74) Representative: Mooser, Sebastian Thomas
(86) International application number: PCT/JP2022/028654
(87) International publication number: WO 2023/008382

(57) **Abstract**

The present invention provides a method for manufacturing a spin wave excitation/detection structure to excite and detect a spin wave. The method includes: forming an insulating magnetic film on a donor substrate, producing a bonded substrate by bonding a surface of the insulating magnetic film on the donor substrate to a surface of a support substrate via a conductive film, removing the donor substrate from the bonded substrate, and forming a conductive line on the insulating magnetic film. The spin wave excitation/detection structure includes the support substrate, the conductive film provided on the support substrate, the insulating magnetic film provided on the conductive film, and the conductive line provided on the insulating magnetic film. This provides the method that can manufacture the spin wave excitation/detection structure, having a structure with high strength, the spin wave that can be excited with high intensity, and the spin wave that can be excited with broad frequency bandwidth.

## Description

### TECHNICAL FIELD

The present invention relates to a method for manufacturing a spin wave excitation/detection structure.

### BACKGROUND ART

With explosive increase in an amount of information handled by such as a recent internet; acceleration of a CPU, acceleration of intermediate and long-range communication thanks to RF (high frequency) and optical communication, increase in a data storage capacity, and miniaturization of each part have been developed rapidly. However, an improvement in a processing speed has bottlenecks in that (1) a heat generation problem due to performance improvement by further miniaturization is approaching physical limitation, (2) a development rate of data communication speed between the CPU and a memory (Latency) is slowing down. Concerning the above-described problem (1), replacement to a carrier with low power consumption has been called for. The above-described problem (2) has also become conspicuous, along with a recent development of peripheral technology.

As for a sensor group that can detect sensation at a comparable level with a human being (so-called artificial skin), for example, in case of enabling access by using a conventional electric device, the number of transistors becomes enormous, a control unit is enlarged, and a communication delay is caused at the same time. Moreover, regarding a three-dimensional display with high resolution for a medical field and an entertainment field, an expansion of a viewing angle (secured at approximately 45 degrees) allows multiple people to watch simultaneously. On the other hand, when this display is configured by an electric device, the number of transistors is still enormous. Consequently, communication delay or heat generation from a wiring cannot be ignored, thus burnt out of the wiring or an unstable operation due to heat generated is concerned.

Thus, with an increasing number of situations where large numbers of elements are required and a rapid increase in the degree of integration, a CMOS-based system has become the bottleneck of an entire application regarding speed and miniaturization.

Regarding such a problem of a system in which a conventional CMOS is used, technology attempts to solve this problem using a spin wave.

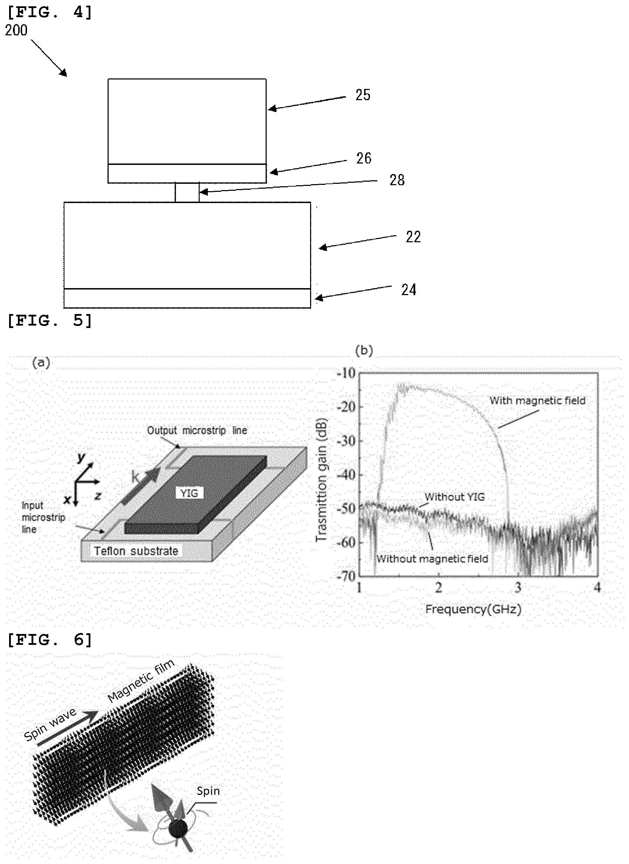

The spin wave (spin wave) is a phase wave generated by magnetization (spin) in a magnetic material. This wave is also called a magnetostatic wave (magnetostatic wave). In the magnetic material, a large number of spins are contained, as shown in FIG. 6. The plane where the timing (phase) of the rotation of these spins is aligned creates a wavefront. When the wavefront propagates, information is transmitted. This is the spin wave, and information can be transmitted without a charge transfer. The spin wave is a phenomenon related only to the magnetism of a material and not to the electrical properties. In other words, this wave propagates as long as the magnetic material is used, regardless of whether an electric conductor or an insulator is used. Consequently, by using the insulator, the wiring, in which an electric current does not flow through but the spin wave propagates, can be produced. Moreover, this spin wave is the wave having a GHz (gigahertz) band, thus fast enough for information processing.

In this way, since the spin wave is a method to transmit information with no charge transfer being required, thus has attracted attention as a potential information processing device with ultra-low power consumption in the next generation. Basic logic circuits such as an XNOR circuit [see Non Patent Document 1], an AND circuit, and an OR circuit [see Non Patent Document 2] are already in the research stage of being demonstrated. The basic elements have been demonstrated, thus, in the present situation, more complex and practical circuits and applications are proposed, demonstrated, and patented. Recently, a study has disclosed that a computation shows that a compact address decoder can be manufactured by using the spin wave (see Patent Document 1). In addition to the development of functionality, miniaturization of size has also progressed. Miniaturization to a micrometer and a nanoscale is considered to be going to move on.

Several methods to generate the spin wave exist, but currently, a technique to generate the spin wave by using the electric current is mainstream.

Patent Document 2 discloses the spin wave excitation structure of a coplanar waveguide type (a complete type in one layer). This spin wave excitation structure(an antenna) is a type in which a copper wire for a signal level and a copper wire for a ground level is formed in one layer. A structure, as disclosed in Patent Document 2, allows an input of high-frequency electrical signals. As described above, this structure is called the coplanar waveguide structure and is a widely known structure. An antenna part can be produced in a completed single layer and can be minimized to a nanometer scale, thus widely used. However, the spin wave (magnetostatic wave) that can be generated has a problem in which the frequency bandwidth of the wave is narrow.

Patent Document 3 discloses the spin wave excitation structure of a microstrip line type. The microstrip line is a structure in which a single current-flowing copper wire (signal level) is placed on a medium through which the spin wave propagates, and a ground level is placed below the medium (YIG (yttrium iron garnet) is shown as an example in Patent Document 3) through which the spin wave propagates.

The microstrip line type structure, disclosed in Patent Document 3, has an advantage where the spin wave that can be generated has a wide band. On the other hand, the signal level and the ground level step over YIG and form a multilevel structure, thus, the integration is difficult to achieve.

With advancement of the miniaturization and integration, as making the microstrip line narrower, a distance between the signal level and the ground level (= a thickness of YIG) is intact, thus a high-frequency rotating magnet field cannot be produced well in the medium in which the spin wave propagates, and thus an intensity of the spin wave decreases. When the signal level and ground level are close, and the more YIG is interposed between, the spin wave intensity that can be excited is increased.

When making the microstrip line narrower, thinning YIG simultaneously can be considered a technique to maintain the intensity of the spin wave. However, when YIG has a thickness of 1 micrometer or less, YIG is unable to self-support (YIG may crack). Consequently, YIG is typically handled in a state of being placed on a substrate having a thickness of 100 micrometer class, thus a study of structure is conducted within such range.

Specifically, a conductor (often copper wire) called the microstrip line (Microstrip line) is used, as shown in FIG. 5(a). Copper is film-formed on an entire surface of a Teflon (registered trademark) substrate of a lower side of the Teflon (registered trademark) substrate (Teflon substrate). The thickness of the copper film is about 10 um. The copper wire on the Teflon (registered trademark) substrate has a width of about 10 um and a thickness of about 10 um, too. When an electric current is applied to this line, a rotating magnetic field that rotates at a speed of about GHz is generated around this copper wire. Under a condition when a direct current magnetic field is applied to a region where this rotating magnetic field is generated, and if a magnetic insulator (a material called YIG in FIG. 5(a)) is placed on the region, the spin wave is excited by the rotating magnetic field. As a result, the spin wave is propagated from one microstrip line (an input microstrip line, Input microstrip line) to another microstrip line (an output microstrip line, Output microstrip line). At the point of the output microstrip line, reversely, the rotating magnetic field generated by the spin wave generates an electric current in the microstrip line. In other words, making the electric current flow excites the spin wave. Then, the propagation of the spin wave is generated, and then an operation is performed during the propagation, and then a result of the operation is propagated. Then, a conversion of the spin wave to the electric current is performed, and the result is detected as an electric signal. This means a spin wave propagation spectrum can be obtained, as shown in the "with magnetic field" line in FIG. 5(b). "Without YIG" in FIG. 5(b) shows a spectrum without YIG in a structure in FIG. 5(a), "without magnetic field" in FIG. 5(b) shows a spectrum when the direct current magnetic field is not applied in a structure in FIG. 5(a). Moreover, referring to FIG. 5(a), the part of the input microstrip line is the spin wave excitation structure, and the part of the output microstrip line is the spin wave detection structure.

### CITATION LIST

### PATENT LITERATURE

Patent Document 1: JP 2017-162937 A
Patent Document 2: JP 2006-504345 A
Patent Document 3: JP H1-91514 A

### NON PATENT LITERATURE

Non Patent Document 1: Taichi Goto, Takuya Yoshimoto, Bungo Iwamoto, Kei Shimada, Caroline A. Ross, Koji Sekiguchi, Alexander B. Granovsky, Yuichi Nakamura, Hironaga Uchida and Mitsuteru Inoue, "Three port logic gate using forward volume spin wave interference in a thin yttrium iron garnet film", Scientific Reports, 9, 16472 (2019/11/11) .

Non Patent Document 2: Naoki Kanazawa, Taichi Goto, Koji Sekiguchi, Alexander B. Granovsky, Caroline A. Ross, Hiroyuki Takagi, Yuichi Nakamura, Hironaga Uchida and Mitsuteru Inoue, "The role of Snell's law for a magnonic majority gate", Scientific Reports, 7, 7898 (2017/08/11).

### SUMMARY OF INVENTION

### TECHNICAL PROBLEM

As described above, spin wave devices, attracting attention as the latest information processing devices, also have a problem. This is a low-intensity of a spin wave.

A currently used spin wave excitation structure using electricity (also known as a transducer or an antenna) (which can also be a spin-wave detection structure, as described above) is shown in FIG. 4 when a cross-sectional view is illustrated. A conventional spin wave excitation/detection structure 200 has a structure in which a copper film 24 is under a dielectric substrate 22, and a YIG film 26 with gadolinium gallium garnet substrate 25 is mounted on a copper wire 28. This is not suited for miniaturization and integration. This is because if the miniaturization is achieved by a method according to simple scale down, an excitation efficiency becomes significantly low, and a bandwidth becomes significantly narrow.

The present invention has been made in view of the above-described problem. An object of the present invention is to provide a method for manufacturing a spin wave excitation/detection structure having a structure with high strength, the spin wave that can be excited with high intensity, and the spin wave that can be excited with broad frequency bandwidth.

### SOLUTION TO PROBLEM

To achieve the object, the present invention provides a method for manufacturing a spin wave excitation/detection structure to excite and detect a spin wave, the method comprising the steps of:
forming an insulating magnetic film on a donor substrate;
producing a bonded substrate by bonding a surface of the insulating magnetic film on the donor substrate to a surface of a support substrate via a conductive film;
removing the donor substrate from the bonded substrate; and
forming a conductive line on the insulating magnetic film; wherein
the spin wave excitation/detection structure comprises the support substrate, the conductive film provided on the support substrate, the insulating magnetic film provided on the conductive film, and the conductive line provided on the insulating magnetic film.

According to such a method for manufacturing the spin wave excitation/detection structure, the surface of the insulating magnetic film and the surface of the support substrate can be bonded via the conductive film by a simple and easy bonding method. Moreover, the spin wave excitation/detection structure manufactured by such a manufacturing method has a structure with high strength, the spin wave that can be excited with high intensity, and the spin wave that can be excited with broad frequency bandwidth.

In this case, the conductive film can be formed on the support substrate; and the conductive film formed on the support substrate can be bonded to the surface of the insulating magnetic film.

In addition, the conductive film can be formed on the insulating magnetic film; and the conductive film formed on the insulating magnetic film can be bonded to the surface of the support substrate.

Moreover, the conductive film can be formed on both the support substrate and the insulating magnetic film, a first conductive film formed on the support substrate and a second conductive film formed on the insulating magnetic film can also be bonded.

By any of these bonding methods, the surface of the insulating magnetic film on the donor substrate and the surface of the support substrate can be easily bonded via the conductive film.

Note that the insulating magnetic film is preferably a magnetic garnet. Furthermore, the insulating magnetic film is preferably an yttrium iron garnet.

By using this kind of the insulating magnetic film, an excellent spin wave can be excited. In addition, the detection of the spin wave can also be performed without any problem.

Moreover, in this case, the donor substrate is preferably a substrate made of a paramagnetic garnet.

Thus, by using a substrate made of paramagnetic garnet as the donor substrate and the insulating magnetic film formed on the donor substrate made of magnetic garnet; a magnetic garnet film, which is an insulating magnetic material, can be formed with an excellent structure because the garnets have a similar structure to each other.

Moreover, in the inventive method for manufacturing the spin wave excitation/detection structure, removing the donor substrate from the bonded substrate can be performed by grinding and polishing.

Furthermore, in the inventive method for manufacturing the spin wave excitation/detection structure, the method further includes: implanting an ion into the insulating magnetic film to form an ion-implanted surface after forming the insulating magnetic film on the donor substrate and removing the donor substrate from the bonded substrate being enabled by dividing the bonded substrate along the ion-implanted surface after producing the bonded substrate.

These methods can be used to remove the donor substrate from the bonded substrate.

In addition, the conductive film and the conductive line can contain at least any one of copper, aluminum, gold, silver, platinum, iron, transparent conductor, superconductor, graphene, and magnetic material with conductivity.

In the inventive method for manufacturing the spin wave excitation/detection structure, the above kinds of conductors, as well as copper, can be used as a conductor component.

Furthermore, the support substrate can be at least any one of a silicon substrate, a dielectric substrate, a conductive substrate, an insulating substrate, a magnetic substrate, a nonmagnetic substrate, a wood substrate, and a stone substrate.

In the inventive method for manufacturing the spin wave excitation/detection structure, the silicon substrate or other substrates of the kinds described above can be used for the support substrate.

### ADVANTAGEOUS EFFECTS OF INVENTION

The inventive method for manufacturing the spin wave excitation/detection structure can bond the surface of the insulating magnetic film and the surface of the support substrate via the conductive film by a simple and easy bonding method. Moreover, the spin wave excitation/detection structure manufactured by such a manufacturing method has a structure with high strength and the spin wave that can be excited with high intensity. In addition, a frequency bandwidth of the spin wave that can be excited is broad. In more detail, the spin wave excitation/detection structure manufactured by the inventive manufacturing method has the insulating magnetic film and the support substrate via the conductive film and has a characteristic of a wide excitation bandwidth of the microstrip line, the signal level and the ground level being close, and the insulating magnetic film sandwiched between these levels as a propagating region of the excited spin wave. Thus, the intensity of the spin wave excited is high. Moreover, the insulating magnetic film is bonded to the support substrate via the conductive film, which has an effect on high mechanical strength of the structure and an ability for handling.

### BRIEF DESCRIPTION OF DRAWINGS

FIG. 1 is a flowchart illustrating an example of a method for manufacturing a spin wave excitation/detection structure according to the present invention.
FIG. 2 is a flowchart illustrating another example of a method for manufacturing a spin wave excitation/detection structure according to the present invention.
FIG. 3 is a view illustrating an example of a schematic cross-sectional view of a spin wave excitation/detection structure manufactured by a method for manufacturing a spin wave excitation/detection structure according to the present invention.
FIG. 4 is a view illustrating an example of a schematic cross-sectional view of a structure of a conventional spin wave excitation/detection structure.
FIG. 5(a) is a view illustrating a perspective view of a spin wave excitation/detection structure of a conventional microstrip type, and (b) is a spin wave propagation spectrum of the structure.
FIG. 6 is a view illustrating a schematic view to describe a spin wave.

### DESCRIPTION OF EMBODIMENTS

Hereinafter, embodiments of the present invention will be described. However, the present invention is not limited thereto.

As described above, a currently used spin wave excitation structure (also known as a transducer or an antenna) using electricity, shown in FIG. 4, is not suitable for miniaturization and integration. Since an excitation efficiency becomes extremely low and a bandwidth becomes extremely narrow when miniaturization is done by a simple scaling down method. Specifically, an intensity of a spin wave decreases when a copper wire 28 of the upper portion is made thinner and narrower for miniaturization and integration. This is because the copper wire 28 of the upper portion and a copper film 24 of the lower portion are too far. Consequently, a technique to make a dielectric substrate 22 portion thinner comes to mind, but this makes a rotating magnetic field unable to generate in a YIG film 26 of the upper portion. Therefore, the YIG film 26 needs to be located between the copper wire 28 of the upper portion and the copper film 24 of the lower portion. Furthermore, if a sample is too thin, the sample falls apart thus a substrate (the dielectric substrate 22) is necessary.

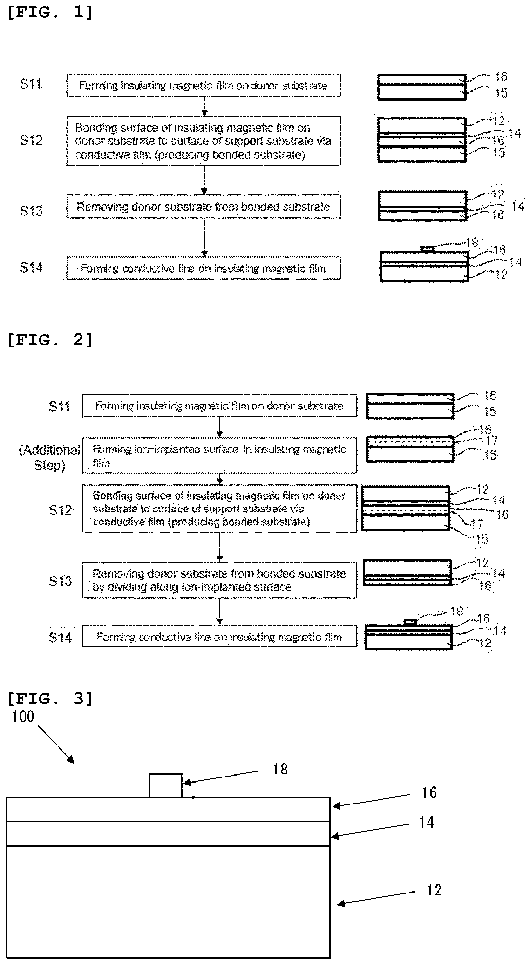

The present inventors devised a structure shown in FIG. 3 to be useful based on a problem with the conventional spin wave excitation/detection structure 200 shown in FIG. 4, and found out the usefulness through calculations. Therefore, a proposal is given for the structure of a spin wave excitation/detection structure 100, shown in FIG. 3.

FIG. 3 shows an example of the spin wave excitation/detection structure 100 to be manufactured by the inventive manufacturing method. The spin wave excitation/detection structure 100 can excite the spin wave. Moreover, this can also detect the spin wave. The spin wave excitation/detection structure 100 includes a support substrate 12, a conductive film 14 provided on the support substrate 12, an insulating magnetic film 16 provided on the conductive film 14, and a conductive line 18 provided on the insulating magnetic film 16. In other words, the support substrate 12, the conductive film 14, the insulating magnetic film 16, and the conductive line 18 are laminated in this order.

The spin wave excitation/detection structure 100 makes the conductive line 18 of the upper portion an electric signal level and the conductive film 14 of the lower portion an electric ground level. Then, by supplying a high-frequency signal in the gigahertz band between the two levels above, the structure 100 excites the spin wave within the insulating magnetic film 16.

The manufacture of the spin wave excitation/detection structure 100, shown in FIG. 3, is performed by a method including: forming an insulating magnetic film on a donor substrate, producing a bonded substrate by bonding a surface of the insulating magnetic film on the donor substrate to a surface of a support substrate via a conductive film, removing the donor substrate from the bonded substrate; and forming a conductive line on the insulating magnetic film.

FIG. 1 shows an example of the inventive method for manufacturing the spin wave excitation/detection structure. Hereinafter, each step is described in more detail.

In the inventive method for manufacturing the spin wave excitation/detection structure, to begin with, as shown in step S11 of FIG. 1, the insulating magnetic film 16 is formed on the donor substrate 15.

Various materials are usable for the donor substrate 15 and the insulating magnetic film 16. Among them, the donor substrate 15 is preferably a substrate made of paramagnetic garnet. As for paramagnetic garnet, for example, the paramagnetic garnet substrate such as a gadolinium gallium garnet Gd₃Ga₅O₁₂ (GGG) can be used. The insulating magnetic film 16 is preferably made of a magnetic garnet. In particular, the insulating magnetic film 16 is preferably made of a yttrium iron garnet (YIG). Furthermore, yttrium iron garnet can be a material based on Y₃Fe₅O₁₂, with a Y portion or a Fe portion being replaced by other elements. By using the magnetic garnet, especially the yttrium iron garnet, as the insulating magnetic film 16, the spin wave excitation/detection structure 100 shown in FIG. 3 can excite an excellent spin wave. Moreover, the detection of the spin wave can be performed without any problems.

Forming the insulating magnetic film on the donor substrate is preferably performed by liquid phase epitaxy. For example, a single crystal of the yttrium iron garnet Y₃Fe_{S}O₁₂(YIG), which is grown by liquid phase epitaxial growth on the paramagnetic garnet substrate such as gadolinium gallium garnet Gd₃Ga₅O₁₂ (GGG), can be formed as the insulating magnetic film 16.

A thickness of the donor substrate 15 is not particularly limited, but the thickness of 100 um or more can secure a mechanical strength. This thickness is further preferable to have 300 um or more, and the thickness of 500 um or more is particularly preferable.

A thickness of the insulating magnetic film 16 formed on the donor substrate 15 is not particularly limited. As described later, the thickness of the insulating magnetic film 16 is preferably 10 um or less when the spin wave excitation/detection structure 100 is finally manufactured. The thickness of the insulating magnetic film 16 formed on the donor substrate 15 at this stage can be decided, considering economic efficiency, for example, and can be such as 200 um or less.

As described above, after the formation of the insulating magnetic film 16 on the donor substrate 15, as shown in step S12 of FIG. 1, the surface of the insulating magnetic film 16 on the donor substrate 15 is bonded to the surface of the support substrate 12 via the conductive film 14, thereby producing the bonded substrate.

The support substrate 12 can be at least any one of a silicon substrate, a dielectric substrate, a conductive substrate, an insulating substrate, a magnetic substrate, a nonmagnetic substrate, a wood substrate, and a stone substrate. In this way, various support substrates can be used. Among these, the silicon substrate can be obtained inexpensively and of excellent quality, and is preferred as the support substrate 12. As for the insulating substrate, glass, quartz, sapphire, aluminum nitride, and alumina, for example, can be exemplified. Regarding the nonmagnetic substrate, a paramagnetic garnet substrate can also be used. A thickness of support substrate 12 is preferably 100 um or more and 500 um or less. When the thickness of the support substrate 12 is 100 um or more, the spin wave excitation/detection structure 100 to be manufactured has high mechanical strength and easier handling. Moreover, the thickness of the support substrate 12 with 500 um or less is sufficient because sufficient mechanical strength can be secured in the spin wave excitation/detection structure 100 to be manufactured.

The support substrate 12 is desired to be mirror-polished before the bonding. Moreover, the surface of the insulating magnetic film 16 formed on the donor substrate 15 is preferably planarized by polishing.

Various methods can be used for the bonding. For example, the conductive film can be formed only on the support substrate 12, then the conductive film formed on the support substrate 12 can be bonded to the surface of the insulating magnetic film 16. Moreover, the conductive film can be formed only on the insulating magnetic film 16, then, the conductive film formed on the insulating magnetic film 16 can be bonded to the surface of the support substrate 12. Furthermore, the conductive film may be formed on both the support substrate 12 and the insulating magnetic film 16, then, a first conductive film formed on the support substrate 12 may be bonded to a second conductive film formed on the insulating magnetic film 16.

In any case, the conductive film can be formed by such as sputtering. Depending on the material of the conductive film, bonding can be performed only by pressure bonding at room temperature. Moreover, heating may be used if necessary. An adhesive may also be used.

Then, as shown in step S13 of FIG. 1, the donor substrate 15 is removed from the bonded substrate. Removal of the donor substrate 15 from the bonded substrate can be performed by grinding and polishing. After removing the donor substrate 15, the thickness of the insulating magnetic film 16 is preferably 10 um or less by grinding and polishing. The thickness of this insulating magnetic film 16 is more preferably 5 um or less, and particularly preferably 1 um or less. In this way, the insulating magnetic film 16 can be as thin as 10 um or less in the spin wave excitation/detection structure 100 to be manufactured.

Then, the conductive line 18 is formed on the insulating magnetic film 16, as shown in step S14 of FIG. 1. The formation method of the conductive line 18 is not particularly limited, and such photolithography can be appropriately applied.

According to the method for manufacturing the spin wave excitation/detection structure along with the above steps S11 to S14, the spin wave excitation/detection structure 100 shown in FIG. 3 can be manufactured.

In the present invention, the conductive film 14 and the conductive line 18 can contain at least any one of copper, aluminum, gold, silver, platinum, iron, transparent conductor, superconductor, graphene, and magnetic material with conductivity. Copper is particularly preferred among these. Moreover, other conductors can be used for the material for the conductive film 14 and the conductive line 18, for example, carbon nanotube or organic conductive material can be used. Furthermore, the material of the conductive film 14 and the conductive line 18 is preferred to have higher conductivity than the support substrate 12 or the insulating magnetic film 16. The component of the conductive film 14 and the conductive line 18 may be the same or different.

Among these, the conductive line 18 preferably has a thickness of 1 um or less and a width of 5 um or less. This thickness of 0.5 um or less is even more preferable, and 0.1 um or less is particularly preferable. Moreover, a width of 2 um or less is even more preferable, and 0.5 um or less is particularly preferable. Furthermore, a lower limit of the thickness of the conductive line 18 is not particularly limited, however, if the thickness is too thin, the line is separated and split, and conductivity cannot be maintained, thus, 0.01 um or more is preferable. Moreover, one conductive line 18 of the upper portion is sufficient. However, the lines may be two or more.

In addition, the conductive film 14 preferably has the thickness of 1 um or less. This thickness is even more preferably 0.5 um or less, and 0.1 um or less is particularly preferable. Moreover, a lower limit of the thickness of the conductive film 14 is not particularly limited; however, if the thickness is too thin, the film is separated and split, and conductivity cannot be maintained. Thus, 0.01 um or more is preferable.

A measurement of a component of the spin wave excitation/detection structure 100 to be manufactured by the inventive manufacturing method is preferred as enumerated above, and the spin wave excitation/detection structure 100 can be miniaturized.

Besides, in the inventive method for manufacturing the spin wave excitation/detection structure, the donor substrate can be removed from the bonded substrate of step S13, as shown in FIG. 2.

In an aspect of FIG. 2, step S11 forms the insulating magnetic film 16 on the donor substrate 15 as in an aspect of FIG. 1. After that, the insulating magnetic film 16 has a further step to be ion-implanted to form an ion-implanted surface 17 (ion-implanted layer) ("Additional step" in FIG. 2). A hydrogen ion and a helium ion can be used as an ion which is ion-implanted.

After that, step S12, which is a bonding step, is performed as well in the aspect of FIG. 1. In a next step S13, a step in which the donor substrate 15 is removed from the bonded substrate is performed by dividing the bonded substrate along the ion-implanted surface 17. Consequently, the donor substrate 15 can be removed from the bonded substrate. Moreover, a part of the insulating magnetic film 16 formed on the donor substrate 15 also remains on the donor substrate 15. This divide can be performed by applying a mechanical shock toward the ion-implanted surface 17. Furthermore, heating can be applied at the same time.

After the divide (delamination), such as polishing may be performed on a divided surface on a surface of the insulating magnetic film 16.

Simultaneously with removing the donor substrate 15, the thickness of the insulating magnetic film 16 can be adjusted by adjusting the depth of ion implantation in the aforementioned ion implantation step. The thickness of this insulating magnetic film 16 is more preferably 5 um or less, 1 um or less is particularly preferable. In this way, the insulating magnetic film 16 can be as thin as 10 um or less in the spin wave excitation/detection structure 100 to be manufactured.

In this technique, the insulating magnetic film on a delaminated donor substrate 15, for example, can be mirror-finished again and ion-implanted to be put into the same step again.

After the divide of the bonded substrate, a surface polishing can be performed as appropriate. Then, as in FIG. 1, the conductive line 18 is formed on the insulating magnetic film 16.

As described above, the spin wave excitation/detection structure to be manufactured according to the inventive manufacturing method is expected to become an indispensable component as an excitation structure of the spin wave (a conversion element between electricity and the spin wave) in a spin-wave computer, which is said to make a next-generation CPU.

The spin wave is a phase wave that propagates with an electron in a state of being fixed in place. Thus, in theory, a loss called a Joule heating loss that is supposed to be generated by charge transfer is zero. Moreover, YIG, in particular, is an insulator and does not generate an eddy current because of a magnetic oxide material. In this way, the spin wave has no loss in theory within both elements of a stationary electric current and an eddy current and has the potential to replace all of the wiring, and logic elements, such as NAND or NOR that CMOS has realized. That is to say, the realizability of a cold computer without heat generation is expected in combination with nanotechnology.

A ripple effect of the inventive spin wave excitation/detection structure toward related fields includes the following.

### (1) Computer

The ripple effect affects all fields where computers are currently used, and device fields where such as CPUs and other arithmetic elements are mounted. In particular, useful in this regard is a situation where the computer is required at a millimeter or a micrometer scale. For example, a sensor and a microchip, which are increasingly used in a mobile device, a wearable device, and such as household appliances, are included.

### (2) High Frequency, wireless, communications field

The spin wave is the same as a microwave in light of a responsive wave of an order of GHz, however, a conversion to the wave propagating into the magnetic field makes a wavelength shorten in order of a hundredfold or more. Considering this from the device (the element) size, this means that an entire chip can be made a hundredfold smaller. Conventionally, the miniaturization of an analog high-frequency device has not progressed much, and the device has a size far from being portable. Therefore, the miniaturization of the high-frequency device is expected by realization of a spin wave device, including a spin wave phase modulation element.

### EXAMPLE

Hereinafter, the present invention will be more specifically described with reference to Examples of the present invention. However, the present invention is not limited thereto.

### [Example 1]

A spin wave excitation/detection structure was manufactured according to the inventive method for manufacturing the spin wave excitation/detection structure shown in FIG. 1.

A GGG (Gd₃Ga₅O₁₂) substrate having a diameter of 3 inches (7.62 centimeters) was provided as a donor substrate 15. A single crystal ((BiYLu)₃(FeM)₅O₁₂), being a magnetic garnet film, was grown 100 um as an insulating magnetic film 16 on the donor substrate 15 by an LPE method (a liquid phase epitaxial method)(step S11). At this point, M was an element substitutable with Fe in a garnet structure, and Ga, Al, Sc, and In could be listed, in this case, Ga was specifically used. Regarding a method for single crystal film forming for this case, a method disclosed in JP H03-223199 A was applied correspondingly. Then, a surface of the insulating magnetic film 16 was mirror-polished. After the mirror polishing, copper (Cu) was film-formed 100 nm as a conductive film 14 by a sputtering method.

On the other hand, a mirror-polished Si substrate having a diameter of 3 inches (7.62 centimeters) was provided as a support substrate 12 (carrier substrate). Copper (Cu) was film-formed 100 nm on the support substrate 12 as the conductive film 14 by the sputtering method.

Then, in an apparatus under a vacuum, the copper-film-formed surfaces of both substrates were superimposed, pressurized, and heated, thereby obtaining a structure (bonded substrate) in which the support substrate 12, the donor substrate 15, the insulating magnetic film 16, and the conductive film 14 were integrated (step S12).

The donor substrate 15 (GGG substrate) side of the bonded substrate taken out from the apparatus was ground, then polished, and made a magnetic garnet film, being the insulating magnetic film 16, which had a thickness of 1 to 10 um (step S13).

Then, a copper wire was formed on the insulating magnetic film 16 as the conductive line 18 (step S14). Consequently, spin wave excitation/detection structure 100 was obtained.

### [Example 2]

A spin wave excitation/detection structure was manufactured according to the inventive method for manufacturing the spin wave excitation/detection structure shown in FIG. 2.

A GGG (Gd₃Ga₅O₁₂) substrate having a diameter of 3 inches (7.62 centimeters) was provided as a donor substrate 15. A single crystal ((BiYLu)₃(FeM)₅O₁₂), being a magnetic garnet film was grown 110 um as an insulating magnetic film 16 on this donor substrate 15 by an LPE method (a liquid phase epitaxial method) (step S11). At this point, Ga was used as M. Regarding a method for single crystal film forming for this case, a method disclosed in JP H03-223199 A was applied correspondingly. Then, a surface of the insulating magnetic film 16 was mirror-polished. An ion implantation was performed on the mirror-polished surface. A hydrogen ion was used as a type of ion. A technique for this case was applied corresponding to the technique disclosed in JP 2020-043591 A. Then, copper (Cu) was film-formed 100 nm as a conductive film 14 on a mirror-polished surface (ion-implanted surface) by a sputtering method.

On the other hand, a mirror polished Si substrate surface having a diameter of 3 inches (7.62 centimeters) was provided as a support substrate 12 (carrier substrate). Copper (Cu) was film-formed 100 nm on the support substrate 12 as the conductive film 14 by the sputtering method.

Then, in an apparatus under a vacuum, the copper-film-formed surfaces of both substrates were superimposed, pressurized, and heated, thereby obtaining a structure (bonded substrate ) in which the support substrate 12, the donor substrate 15, the insulating magnetic film 16, and the conductive film 14 were integrated (step S12).

The bonded substrate having an integrated structure was heated and applied a mechanical impact from a side surface, thus, the substrate was divided along an ion-implanted surface and delaminated (step S13). A surface of the insulating magnetic film 16 was then mirror-finished and configured to form a magnetic garnet film having a thickness of 0.3 to 2 µm.

Then, a copper wire was formed on the insulating magnetic film 16 as the conductive line 18 (step S14). Consequently, spin wave excitation/detection structure 100 was obtained.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for manufacturing a spin wave excitation/detection structure to excite and detect a spin wave, the method comprising the steps of:
forming an insulating magnetic film on a donor substrate;
producing a bonded substrate by bonding a surface of the insulating magnetic film on the donor substrate to a surface of a support substrate via a conductive film;
removing the donor substrate from the bonded substrate; and
forming a conductive line on the insulating magnetic film; wherein
the spin wave excitation/detection structure comprises the support substrate, the conductive film provided on the support substrate, the insulating magnetic film provided on the conductive film, and the conductive line provided on the insulating magnetic film.

2. The method for manufacturing the spin wave excitation/detection structure according to claim 1, wherein
the conductive film is formed on the support substrate, and the conductive film formed on the support substrate is bonded to the surface of the insulating magnetic film.

3. The method for manufacturing the spin wave excitation/detection structure according to claim 1, wherein
the conductive film is formed on the insulating magnetic film, and the conductive film formed on the insulating magnetic film is bonded to the surface of the support substrate.

4. The method for manufacturing the spin wave excitation/detection structure according to claim 1, wherein
the conductive film is formed on both the support substrate and the insulating magnetic film, a first conductive film formed on the support substrate and a second conductive film formed on the insulating magnetic film are bonded.

5. The method for manufacturing the spin wave excitation/detection structure according to any one of claims 1 to 4, wherein
the insulating magnetic film is a magnetic garnet.

6. The method for manufacturing the spin wave excitation/detection structure according to claim 5, wherein
the insulating magnetic film is an yttrium iron garnet.

7. The method for manufacturing the spin wave excitation/detection structure according to claim 5 or 6, wherein
the donor substrate is a substrate made of a paramagnetic garnet.

8. The method for manufacturing the spin wave excitation/detection structure according to any one of claims 1 to 7, wherein
removing the donor substrate from the bonded substrate is performed by grinding and polishing.

9. The method for manufacturing the spin wave excitation/detection structure according to any one of claims 1 to 7, the method further comprising:
implanting an ion into the insulating magnetic film to form an ion-implanted surface after forming the insulating magnetic film on the donor substrate, and
removing the donor substrate from the bonded substrate by dividing the bonded substrate along the ion-implanted surface after producing the bonded substrate.

10. The method for manufacturing the spin wave excitation/detection structure according to any one of claims 1 to 9, wherein
the conductive film and the conductive line contain at least any one of copper, aluminum, gold, silver, platinum, iron, transparent conductor, superconductor, graphene, and magnetic material with conductivity.

11. The method for manufacturing the spin wave excitation/detection structure according to any one of claims 1 to 10, wherein
the support substrate is at least any one of a silicon substrate, a dielectric substrate, a conductive substrate, an insulating substrate, a magnetic substrate, a nonmagnetic substrate, a wood substrate, and a stone substrate.
